# FASCICULE DE BREVET EUROPEEN

(11) **EP 4 038 355 B1**
(45) Date de publication et mention de la délivrance du brevet: **18.09.2024**
(21) Numéro de dépôt: 20781004.5
(22) Date de dépôt: 28.09.2020
(51) Int. Cl.: G01J 5/02, G01J 5/04, G01J 5/10, B81B 7/00, B81C 1/00, H01L 21/02, H01L 21/302, H01L 27/146

(54) **PROCEDE DE FABRICATION D'UN DISPOSITIF DE DETECTION DE RAYONNEMENT ELECTROMAGNETIQUE COMPORTANT UN MATERIAU GETTER**
VERFAHREN ZUR HERSTELLUNG EINER VORRICHTUNG ZUR DETEKTION ELEKTROMAGNETISCHER STRAHLUNG MIT EINEM GETTERMATERIAL
PROCESS FOR MANUFACTURING A DEVICE FOR DETECTING ELECTROMAGNETIC RADIATION, COMPRISING A GETTER MATERIAL

(30) Priorité: 30.09.2019 FR 1910797
(43) Date de publication de la demande: 10.08.2022
(73) Titulaire: Commissariat à l'Energie Atomique et aux Energies Alternatives, 75015 Paris (FR)
(72) Inventeur: DUMONT, Geoffroy, 38054 GRENOBLE cedex 09 (FR); BECKER, Sébastien, 38054 GRENOBLE cedex 09 (FR)
(74) Mandataire: Brevalex
(86) Numéro de dépôt international: PCT/EP2020/077050
(87) Numéro de publication internationale: WO 2021/063861

(56) Documents cités:
- EP-A1- 3 239 670
- CN-A- 106 441 595
- US-A1- 2016 023 888

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité hermétique, un matériau getter étant également situé dans la cavité hermétique. L'invention s'applique notamment au domaine de l'imagerie infrarouge et de la thermographie.

### ÉTAT DE LA TECHNIQUE ANTÉRIEURE

Un dispositif de détection de rayonnement électromagnétique, par exemple infrarouge ou térahertz, peut comprendre une matrice de détecteurs thermiques comportant chacun une portion absorbante apte à absorber le rayonnement électromagnétique à détecter.

Dans le but d'assurer l'isolation thermique des détecteurs thermiques, les portions absorbantes se présentent habituellement sous la forme de membranes suspendues au-dessus du substrat par des piliers d'ancrage, et isolées thermiquement de celui-ci par des bras de maintien. Ces piliers d'ancrage et bras de maintien présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par ces derniers en réponse à l'absorption du rayonnement électromagnétique à détecter. Le circuit de lecture comporte différents niveaux d'interconnexion électrique formés de lignes métalliques séparées les unes des autres par des couches diélectriques dites inter-métal. Au moins un plot de connexion électrique du circuit de lecture est disposé sur le substrat de telle manière qu'il puisse être contacté depuis l'extérieur du dispositif de détection.

Le document EP2581339A1 décrit un exemple de dispositif de détection dont la structure d'encapsulation comporte deux cavités qui communiquent l'une avec l'autre, à savoir une première cavité dans laquelle est situé un détecteur thermique, et une deuxième cavité dans laquelle est situé un matériau getter, lequel assure un pompage gazeux à l'intérieur des cavités. Cependant, cet agencement des deux cavités définies par la même structure d'encapsulation conduit à ce que la surface active du matériau getter est particulièrement réduit, ce qui peut conduire à une diminution des performances du dispositif de détection, et n'est par ailleurs pas adapté au cas où une même cavité hermétique contient une pluralité de détecteurs thermiques.

Le document EP3239670A1 décrit un procédé de fabrication d'un dispositif de détection au moyen de couches sacrificielles minérales ultérieurement supprimées par une gravure chimique humide. Une portion d'un matériau getter est située sous la membrane absorbante, et est protégée de la gravure chimique humide par une couche mince sacrificielle carbonée, laquelle est ensuite supprimée par une gravure chimique sèche. La couche mince sacrificielle carbonée peut notamment être du carbone amorphe ou du polyimide. Cependant, il existe un besoin, d'une part, d'améliorer la tenue mécanique de l'empilement obtenu lors des différentes étapes du procédé de fabrication et notamment lors des étapes de planarisation, et d'autre part, de renforcer la protection du matériau getter lors de la suppression des couches sacrificielles minérales par la gravure chimique humide.

Le document CN 106 441 595 A décrit la réalisation d'une matrice de détecteurs située dans une cavité définie par une couche d'encapsulation 211. Un matériau getter 209 est présent dans la cavité, et est décalé vis-à-vis des détecteurs 206 dans le plan XY.

### EXPOSÉ DE L'INVENTION

L'invention a pour objectif de remédier au moins en partie aux inconvénients de l'art antérieur, et plus particulièrement de proposer un procédé de fabrication d'un dispositif de détection d'un dispositif de détection d'un rayonnement électromagnétique, comportant les étapes suivantes :
o réalisation sur un substrat d'au moins un détecteur thermique, lequel est recouvert par au moins une couche sacrificielle minérale réalisée en un matériau minéral apte à être supprimé par une première gravure chimique ;
o réalisation sur le substrat d'une portion getter réalisée en un matériau métallique à effet getter, laquelle est recouverte par une couche sacrificielle carbonée réalisée en un matériau carboné inerte à la première gravure chimique et apte à être supprimée par une deuxième gravure chimique ;
o réalisation d'une couche mince d'encapsulation comportant une partie supérieure reposant sur la couche sacrificielle minérale et sur la couche sacrificielle carbonée, et une partie périphérique s'étendant au travers de la couche sacrificielle minérale et entourant le détecteur thermique et la portion getter ;
o suppression de la couche sacrificielle minérale par la première gravure chimique ;
o suppression de la couche sacrificielle carbonée par la deuxième gravure chimique.

Selon l'invention, la portion getter est disposée au contact du substrat à distance du détecteur thermique dans un plan parallèle au substrat.

De plus, l'étape de réalisation de la couche sacrificielle carbonée est effectuée après l'étape de réalisation du détecteur thermique, et comporte :
- la réalisation d'une ouverture traversante s'étendant au travers de la couche sacrificielle minérale et débouchant sur le substrat. La portion getter est située dans l'ouverture traversante, à distance d'une bordure latérale définie par la couche sacrificielle minérale et délimitant l'ouverture traversante dans le plan parallèle au substrat. Autrement dit, la portion getter n'est pas au contact de la couche sacrificielle minérale qui l'entoure.
- le dépôt de la couche sacrificielle carbonée de manière à recouvrir la portion getter située dans l'ouverture traversante et à l'entourer dans le plan parallèle au substrat, et à remplir entièrement l'ouverture traversante. Autrement dit, la couche sacrificielle minérale recouvre et est au contact des faces libres de la portion getter dans le plan parallèle au substrat et suivant un axe orthogonal au substrat. La portion getter repose sur le substrat, et est encapsulée par la couche sacrificielle carbonée.

Enfin, la partie supérieure de la couche mince d'encapsulation repose sur la couche sacrificielle minérale et sur la couche sacrificielle carbonée.

Certains aspects préférés mais non limitatifs de ce procédé sont les suivants.

La portion getter peut être disposée entre le détecteur thermique et la partie périphérique de la couche mince d'encapsulation.

La partie périphérique peut comporter une surface interne, orientée vers le détecteur thermique, au contact de la couche sacrificielle carbonée.

La couche sacrificielle minérale et la couche sacrificielle carbonée peuvent présenter des faces supérieures, opposées au substrat, coplanaires.

Le matériau minéral peut comporter au moins de l'oxyde de silicium ou du nitrure de silicium, et la première gravure chimique peut être une attaque à l'acide fluorhydrique en phase vapeur.

Le matériau carboné peut être choisi parmi le carbone amorphe et le polyimide, et la deuxième gravure chimique peut être une gravure sèche par plasma d'oxygène.

Le matériau métallique à effet getter peut être choisi parmi le titane, le zirconium, le vanadium, le chrome, le cobalt, le fer, le manganèse, le palladium, le baryum, et/ou l'aluminium, et un alliage de ces métaux.

Le procédé peut comporter la réalisation d'au moins un premier évent de libération et d'au moins un deuxième évent de libération au travers de la partie supérieure de la couche mince d'encapsulation, le premier évent de libération débouchant sur la couche sacrificielle minérale, et le deuxième évent de libération débouchant sur la couche sacrificielle carbonée.

La réalisation des premier et deuxième évents de libération peut être effectuée avant la première gravure chimique, la couche sacrificielle carbonée sous la partie supérieure de la couche mince d'encapsulation étant au contact de la couche sacrificielle minérale.

La couche mince d'encapsulation peut comporter en outre une partie interne s'étendant à partir de la partie supérieure en direction du substrat, et disposée entre la couche sacrificielle minérale et la couche sacrificielle carbonée, de sorte que la couche sacrificielle carbonée sous la partie supérieure de la couche mince d'encapsulation est au contact des parties supérieure, périphérique et interne de la couche mince d'encapsulation.

L'étape de réalisation des deuxièmes évents de libération peut comporter, outre la formation d'au moins un deuxième évent de libération débouchant sur la couche sacrificielle carbonée, la formation d'au moins un évent situé à la perpendiculaire de la partie interne et assurant une rupture de lien physique, au moins localement, entre la paroi interne et la partie supérieure, assurant ainsi, après la deuxième gravure chimique, une communication entre un premier espace dans lequel est situé le détecteur thermique et un deuxième espace dans lequel est située la portion getter.

La partie interne peut reposer au contact d'une portion carbonée disposée au contact du substrat et être réalisée en un matériau carboné inerte à la première gravure chimique et apte à être supprimé par la deuxième gravure chimique, de sorte que la deuxième gravure chimique assure la suppression de la couche sacrificielle carbonée et rendant libre la portion getter, et assure la suppression de la portion carbonée et formant une communication entre un premier espace dans lequel est situé le détecteur thermique et un deuxième espace dans lequel est située la portion getter.

Plusieurs détecteurs thermiques peuvent être réalisés de manière simultanée, et comporter chacun une membrane adaptée à absorber le rayonnement électromagnétique à détecter, suspendue au-dessus du substrat par des piliers d'ancrage et thermiquement isolée de celui-ci par des bras de maintien.

Par ailleurs, la partie supérieure de la couche mince d'encapsulation peut reposer sur et au contact de la couche sacrificielle minérale, et peut reposer sur et au contact de la couche sacrificielle carbonée.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1F sont des vues schématiques et partielles, en coupe transversale, de différentes étapes d'un procédé de fabrication d'un dispositif de détection selon un premier mode de réalisation ;
les figures 2A à 2F sont des vues schématiques et partielles, en coupe transversale, de différentes étapes d'un procédé de fabrication d'un dispositif de détection selon un deuxième mode de réalisation ;
les figures 3A à 3E sont des vues schématiques et partielles, en coupe transversale, de différentes étapes d'un procédé de fabrication d'un dispositif de détection selon une variante du deuxième mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif de détection de rayonnement électromagnétique adapté à détecter un rayonnement infrarouge ou térahertz. Il comporte au moins un détecteur thermique destiné à être situé dans une cavité hermétique, et un matériau à effet getter qui repose sur le substrat à l'intérieur de la cavité hermétique. Ce matériau à effet getter est un matériau exposé à l'atmosphère de la cavité hermétique et apte à réaliser un pompage gazeux par absorption et/ou adsorption. Il s'agit d'un matériau métallique qui peut être choisi parmi le titane, le zirconium, le vanadium, le chrome, le cobalt, le fer, le manganèse, le palladium, le baryum et/ou l'aluminium, voire un alliage de ces métaux tel que le TiZrV.

Le procédé de fabrication comporte une étape de réalisation du détecteur thermique au moyen d'au moins une couche sacrificielle dite minérale. Cette couche sacrificielle minérale est réalisée en un matériau minéral, ou inorganique. Il s'agit ici d'un matériau diélectrique à base de silicium permettant également la réalisation d'une couche diélectrique inter-métal du circuit de lecture, c'est-à-dire un matériau électriquement isolant, avec par exemple une constante diélectrique, ou permittivité relative, inférieure ou égale à 3,9, permettant de limiter la capacité parasite entre les interconnexions. Ce matériau minéral ne comporte pas de chaînes carbonées, et peut être un oxyde de silicium SiOx ou un nitrure de silicium SiₓN_{y}, voire un matériau organosilicié tel que du SiOC, du SiOCH, ou d'un matériau de type verre fluoré tel que du SiOF. La couche sacrificielle minérale peut être supprimée par une gravure chimique humide telle qu'une attaque chimique en milieu acide, par exemple à l'acide fluorhydrique en phase vapeur (HF vapeur). Par gravure humide, on entend d'une manière générale que l'agent de gravure se présente en phase liquide ou en phase vapeur, et ici, de préférence, en phase vapeur.

Le procédé de fabrication comporte également une étape de réalisation d'une couche sacrificielle dite carbonée, apte à protéger le matériau getter lors de l'étape de gravure chimique humide mise en oeuvre pour supprimer la couche sacrificielle minérale, telle qu'une attaque HF vapeur. Cette couche sacrificielle carbonée comporte un matériau carboné, c'est-à-dire un matériau formé d'au moins un type d'espèce chimique comportant des atomes de carbones. Il peut ainsi s'agir d'un matériau minéral tel que du carbone amorphe, éventuellement de type DLC (pour *Diamond Like Carbon,* en anglais), ou un matériau organique tel que du polyimide. Le carbone de type DLC est du carbone amorphe à fort taux d'hybridation en carbone sp³. De préférence, le matériau carboné ne comporte pas de silicium, de manière à éviter la présence d'éventuels résidus à la suite de l'étape de suppression de cette couche sacrificielle. La couche sacrificielle carbonée est ainsi sensiblement inerte vis-à-vis de la gravure chimique humide effectuée pour supprimer la couche sacrificielle minérale. Par sensiblement inerte, on entend que le matériau carboné ne réagit sensiblement pas avec l'agent de gravure utilisé lors de l'étape de suppression de la couche sacrificielle minérale, voire réagit peu de sorte que la couche sacrificielle carbonée, à l'issue de cette étape de suppression, recouvre toujours entièrement le matériau getter. La couche sacrificielle carbonée peut en outre être supprimée par une gravure chimique telle qu'une gravure chimique sèche dont un agent de gravure est par exemple de l'oxygène contenu dans un plasma.

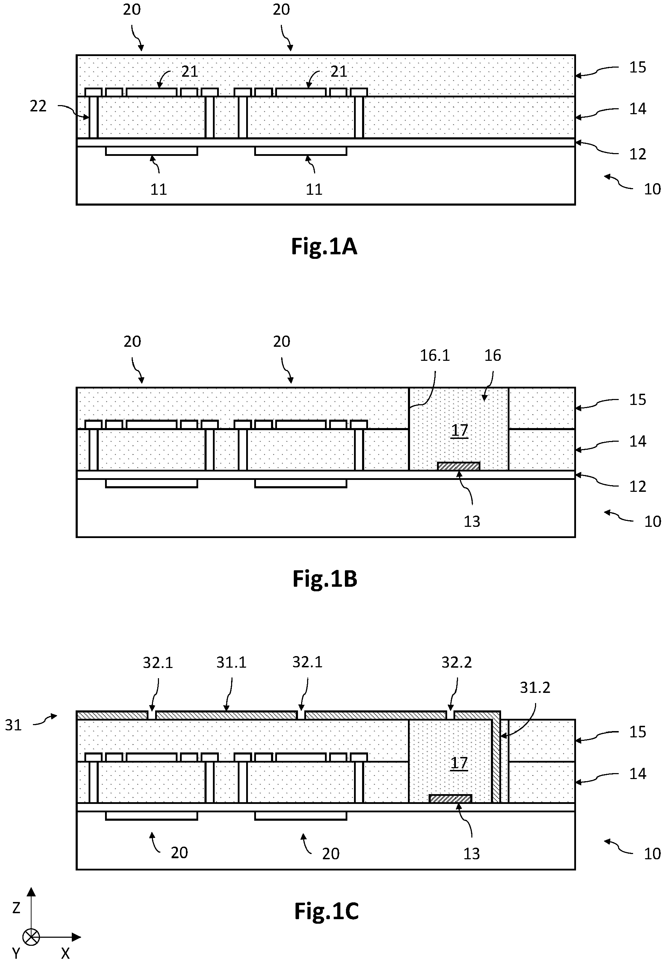

Les figures 1A à 1F illustrent différentes étapes d'un procédé de fabrication d'un dispositif de détection selon un premier mode de réalisation. Seule une partie du dispositif de détection est représentée. A titre d'exemple, les détecteurs thermiques 20 sont ici adaptés à détecter un rayonnement infrarouge dans la gamme LWIR *(Long Wavelength Infrared,* en anglais) dont la longueur d'onde est comprise entre 8µm et 14µm environ. Le dispositif de détection comporte un ou plusieurs détecteurs thermiques 20 situés dans une même cavité hermétique 1, et de préférence ici une matrice de détecteurs thermiques 20 identiques, connectés à un circuit de lecture situé dans le substrat 10 (dit alors substrat de lecture). Les détecteurs thermiques 20 forment ainsi des pixels sensibles agencés périodiquement, et peuvent présenter une dimension latérale dans le plan du substrat de lecture 10, de l'ordre de quelques dizaines de microns, par exemple égale à 10µm environ voire moins.

On définit ici et pour la suite de la description un repère direct tridimensionnel XYZ, où le plan XY est sensiblement parallèle au plan du substrat de lecture 10, l'axe Z étant orienté suivant une direction sensiblement orthogonale au plan du substrat de lecture 10 en direction des détecteurs thermiques 20. Les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'entendent comme étant relatifs à un positionnement croissant lorsqu'on s'éloigne du substrat de lecture 10 suivant la direction +Z.

En référence à la figure 1A, on réalise une matrice de détecteurs thermiques 20 sur le substrat de lecture 10, de telle sorte qu'ils soient recouverts par une couche sacrificielle minérale 15.

Le substrat de lecture 10 est réalisé à base de silicium, et est formé d'un substrat support contenant le circuit de lecture (non représenté) adapté à commander et lire les détecteurs thermiques 20. Le circuit de lecture se présente ici sous la forme d'un circuit intégré CMOS. Il comporte entre autres des portions de lignes conductrices séparées les unes des autres par des couches isolantes inter-métal réalisées en un matériau diélectrique, par exemple un matériau minéral à base de silicium tel qu'un oxyde de silicium SiOₓ, un nitrure de silicium SiNₓ, entre autres.

Le substrat de lecture 10 peut comporter un réflecteur 11 disposé en regard de chaque détecteur thermique 20. Le réflecteur 11 peut être formé par une portion d'une ligne conductrice du dernier niveau d'interconnexion, celle-ci étant réalisée en un matériau adapté à réfléchir le rayonnement électromagnétique à détecter. Il s'étend en regard de la membrane absorbante 21 du détecteur thermique 20, et est destiné à former avec celle-ci une cavité interférentielle quart d'onde vis-à-vis du rayonnement électromagnétique à détecter.

Enfin, le substrat de lecture 10 comporte ici une couche de protection 12 de manière à recouvrir notamment la couche isolante inter-métal supérieure. Cette couche de protection 12 correspond ici à une couche d'arrêt de gravure réalisée en un matériau sensiblement inerte à l'agent de gravure chimique utilisé ultérieurement pour supprimer les couches sacrificielles minérales 14, 15, par exemple au milieu HF en phase vapeur. Cette couche de protection 12 forme ainsi une couche hermétique et chimiquement inerte, et électriquement isolante pour éviter tout court-circuit entre les piliers d'ancrage 22. Elle permet ainsi d'éviter que les couches isolantes inter-métal sous-jacentes ne soient gravées lors de cette étape de suppression des couches sacrificielles minérales 14, 15. Elle peut être formée en un oxyde ou nitrure d'aluminium, en trifluorure d'aluminium, ou en silicium amorphe non intentionnellement dopé.

On réalise ensuite les détecteurs thermiques 20 sur le substrat de lecture 10. Ces étapes de réalisation sont identiques ou similaires à celles décrites notamment dans le document EP3239670A1. Les détecteurs thermiques 20 sont ici des microbolomètres comportant chacun une membrane absorbante 21, i.e. apte à absorber le rayonnement électromagnétique à détecter, suspendue au-dessus du substrat de lecture 10 par des piliers d'ancrage 22, et isolée thermiquement de celui-ci par des bras de maintien. L'obtention de membranes absorbantes 21 est classiquement obtenue par des techniques de micro-usinage de surface consistant à réaliser les piliers d'ancrage 22 au travers d'une première couche sacrificielle minérale 14, et les bras d'isolation thermique ainsi que les membranes absorbantes 21 sur la face supérieure de la première couche sacrificielle. Chaque membrane absorbante 21 comporte en outre un transducteur thermométrique, par exemple un matériau thermistance relié au circuit de lecture par des connexions électriques prévues dans les bras d'isolation thermique et dans les piliers d'ancrage 22. On dépose ensuite une deuxième couche sacrificielle minérale 15, préférentiellement de même nature que la première couche sacrificielle minérale 14. La couche sacrificielle minérale 15 recouvre la couche sacrificielle minérale 14 ainsi que les détecteurs thermiques 20.

En référence à la figure 1B, on réalise une couche sacrificielle carbonée 17 recouvrant un matériau getter reposant sur le substrat de lecture 10, et ici au contact de celui-ci.

Pour cela, on réalise, par photolithographie et gravure, une ouverture traversante 16 qui s'étend au travers des couches sacrificielles minérales 14, 15 jusqu'à déboucher sur le substrat de lecture 10. De préférence, cette ouverture traversante 16 ne débouche pas sur une partie de l'un ou l'autre des détecteurs thermiques 20. Aussi, les détecteurs thermiques 20 restent entièrement recouverts par les couches sacrificielles minérales 14, 15. L'ouverture traversante 16 est délimitée dans le plan XY par une bordure latérale 16.1 définie par les couches sacrificielles minérales 14, 15. Elle présente des dimensions latérales supérieures à celles de la portion getter 13 désirée. A titre d'exemple, pour une portion getter 13 d'une largeur de l'ordre de quelques dizaines à centaines de microns, voire millimètres, par exemple égale à 100µm environ, l'ouverture traversante 16 peut présenter une largeur de l'ordre de quelques dizaines à centaines de microns, par exemple égale à 150µm environ. Ainsi, la distance dans le plan XY entre la portion getter 13 et la bordure latérale 16.1 de l'ouverture traversante définit la dimension de protection de la portion getter 13 par la couche sacrificielle carbonée 17 lors de l'attaque HF vapeur. Dans la mesure où la couche sacrificielle carbonée 17 n'est pas une couche mince dont la dimension de protection est de l'ordre de 0.5µm environ comme dans le document EP3239670A1, la dimension de protection peut être ici de l'ordre de quelques dizaines voire centaines de microns.

On réalise ensuite une portion getter 13 située dans l'ouverture traversante 16 et reposant sur le substrat de lecture 10, ici au contact de ce dernier. Pour cela, on réalise un dépôt en couche mince du matériau getter, de telle sorte qu'il s'étend au contact du substrat de lecture 10. La couche mince du matériau getter peut s'étendre également sur la face supérieure de la couche sacrificielle minérale 15, ainsi que sur la bordure latérale 16.1 de l'ouverture traversante 16. On effectue ensuite une suppression, par exemple par gravure localisée, des parties de la couche mince getter situées sur la face supérieure de la couche sacrificielle minérale 15 et sur la bordure latérale 16.1 de l'ouverture traversante 16. On supprime également une zone périphérique de la couche mince getter qui repose sur le substrat de lecture 10 et vient au contact de la bordure latérale 16.1, pour ne garder qu'une partie centrale. Celle-ci repose donc sur le substrat de lecture 10 et est située à une distance non nulle des couches sacrificielles minérales 14, 15 dans le plan XY. Autrement dit, la portion getter 13 est disposée de manière décalée dans le plan XY vis-à-vis des détecteurs thermiques 20, et n'est pas située en regard (i.e. à la perpendiculaire) de ceux-ci suivant l'axe Z comme dans le document EP3239670A1, ni totalement ni en partie. La portion getter 13 est donc située à distance dans le plan XY, donc à une distance non nulle dans le plan XY, des détecteurs thermiques 20, i.e. de la membrane absorbante et des piliers d'ancrage.

On remplit ensuite entièrement l'ouverture traversante 16 en une couche sacrificielle carbonée 17 qui vient recouvrir entièrement la portion getter 13. Cette couche est dite épaisse dans la mesure où son épaisseur permet de remplir entièrement l'ouverture traversante 16. Elle peut ainsi être réalisée en polyimide ou en carbone amorphe, et ici est en polyimide. Ainsi, la couche sacrificielle carbonée 17 recouvre la portion getter 13 suivant l'axe Z, et l'entoure entièrement dans le plan XY. La couche sacrificielle carbonée 17 sera donc en mesure d'assurer la protection de la portion getter 13 lors d'une gravure chimique, par exemple à l'acide HF en phase vapeur, mise en oeuvre ultérieurement lors de la suppression des couches sacrificielles minérales 14, 15. La dimension de protection dans le plan XY peut alors être de l'ordre de quelques dizaines à centaines de microns. On effectue ensuite une suppression de la partie de la couche sacrificielle carbonée 17 qui recouvre la couche sacrificielle minérale 15, de manière à obtenir une face supérieure plane définie par la couche sacrificielle minérale 15 et par la couche sacrificielle carbonée 17.

En référence à la fig.1C, on réalise ensuite la couche mince d'encapsulation 31 de la structure d'encapsulation 30 de manière similaire à celle décrite dans le document EP3239670A1. Les différentes couches minces de la structure d'encapsulation 30 sont transparentes au rayonnement électromagnétique à détecter. Par des techniques classiques de photolithographie, on grave ensuite localement les couches sacrificielles minérales 14 et 15 jusqu'à déboucher sur le substrat de lecture 10, voire sur une surface de la portion getter 13. Quoi qu'il en soit, les zones gravées prennent ici la forme de tranchées de périmètre continu et fermé entourant les détecteurs thermiques 20 ainsi qu'au moins en partie la portion getter 13.

On procède ensuite au dépôt conforme de la couche mince d'encapsulation 31, ici du silicium amorphe, qui s'étend sur la couche sacrificielle minérale 15 et sur la couche sacrificielle carbonée 17 ainsi que dans les tranchées, par exemple par un dépôt chimique en phase vapeur (CVD pour *Chemical Vapor Deposition,* en anglais). La couche mince d'encapsulation 31 comprend une partie supérieure 31.1 (également appelée paroi supérieure) qui s'étend au-dessus et à distance des détecteurs thermiques 20 et de la portion getter 13, et une partie périphérique 31.2 (également appelée paroi périphérique) qui entoure dans le plan XY de manière continue les détecteurs thermiques 20 et la portion getter 13, et délimitant ultérieurement la cavité hermétique 1 dans le plan XY. La paroi supérieure 31.1 repose donc sur et au contact de la couche sacrificielle minérale 15 et de la couche sacrificielle carbonée 17. La paroi périphérique 31.2 est disposée de manière à, de préférence, avoir sa surface interne orientée vers les détecteurs thermiques 20 au contact de la couche sacrificielle carbonée 17.

Des orifices traversants 32.1, 32.2, formant des évents de libération destinés à permettre l'évacuation des différentes couches sacrificielles hors de la cavité, sont ensuite réalisés par photolithographie et gravure dans la couche mince d'encapsulation 31. Des premiers évents 32.1 sont situés en regard suivant l'axe Z des couches sacrificielles minérales 14, 15, disposés par exemple au-dessus des membranes absorbantes 21, et de préférence au moins un deuxième évent 32.2 est situé en regard suivant l'axe Z de la couche sacrificielle carbonée 17.

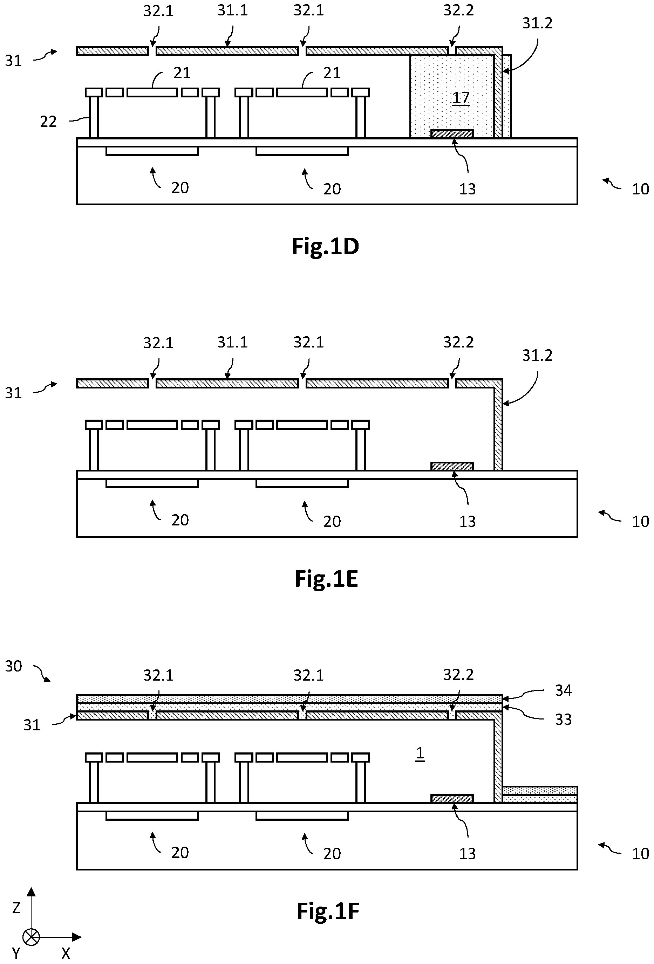

En référence à la fig.1D, on effectue une première gravure chimique adaptée à supprimer les deux couches sacrificielles minérales 14, 15, ici par une gravure chimique humide par attaque à l'acide fluorhydrique en phase vapeur. Les produits de la réaction chimique sont évacués au travers des premiers évents de libération 32.1. Cette gravure chimique humide étant isotrope, on obtient la suspension de la membrane absorbante 21, et on libère les piliers d'ancrage 22. La première gravure chimique est sélective de sorte que la couche sacrificielle carbonée 17 n'est pas supprimée, la portion getter 13 étant alors entièrement protégée de l'attaque HF vapeur. Ainsi, la couche sacrificielle carbonée 17 est libérée, c'est-à-dire que sa surface initialement au contact des couches sacrificielles minérales 14, 15 est maintenant libre. Elle recouvre la portion getter 13 et l'entoure entièrement dans le plan XY. La paroi supérieure 31.1 de la couche mince d'encapsulation 31 repose donc en partie sur la couche sacrificielle carbonée 17.

En référence à la fig.1E, on effectue une deuxième gravure chimique adaptée à supprimer la couche sacrificielle carbonée 17 et donc rendre libre la portion getter 13. La gravure chimique est ici une gravure chimique sèche dont l'agent de gravure est ici de l'oxygène présent dans un plasma. Cette gravure chimique sèche étant isotrope, on préserve l'intégrité des structures libérées tout en facilitant l'accès à l'agent de gravure dans la cavité au travers des évents de libération 32.1, 32.2. Ainsi, la portion getter 13 est libérée, c'est-à-dire qu'elle présente une surface libre (non revêtue), et est donc exposée à l'atmosphère de la cavité.

En référence à la fig.1F, on dépose une couche de scellement 33 sur la couche mince d'encapsulation 31 avec une épaisseur suffisante pour assurer le scellement, i.e. le bouchage, des différents évents de libération 32.1, 32.2. La couche de scellement 33 est transparente au rayonnement électromagnétique à détecter, et peut être réalisée en germanium avec une épaisseur de 1.7µm environ. On dépose ensuite une couche antireflet 34 permettant d'optimiser la transmission du rayonnement électromagnétique au travers de la structure d'encapsulation 30. Cette couche antireflet 34 peut être réalisée en sulfure de zinc avec une épaisseur de 1.2µm environ. On obtient ainsi une cavité hermétique 1 sous vide ou à pression réduite, dans laquelle sont logés les détecteurs thermiques 20 ainsi que la portion getter 13.

On active ensuite la chimisorption de la portion getter 13 en soumettant le dispositif de détection à un traitement thermique adéquat, dans un four ou une étuve, de manière à faire réagir le matériau getter avec des molécules de gaz résiduelles présentes dans la cavité hermétique 1 et former ainsi des composés chimiques stables. On obtient ainsi un niveau de vide maintenu ou abaissé à l'intérieur de la cavité hermétique 1, améliorant ainsi la durée de vie du dispositif de détection.

Ainsi, le procédé de fabrication permet d'obtenir un dispositif de détection comportant un ou plusieurs détecteurs thermiques 20 ainsi qu'une portion getter 13 tous situés dans une cavité hermétique 1. La portion getter 13 est située à distance dans le plan XY des détecteurs thermiques, i.e. située de manière décalée (distance non nulle) dans le plan XY par rapport aux détecteurs thermiques 20, et de préférence est située entre les détecteurs thermiques 20 et la paroi périphérique 31.2 de la couche mince d'encapsulation 31. Elle a été protégée vis-à-vis de la première gravure chimique par une couche épaisse sacrificielle carbonée, laquelle participe à supporter la couche mince d'encapsulation 31 suivant l'axe Z avec les couches sacrificielles minérales 14, 15.

Le maintien mécanique des couches sacrificielles minérales 14, 15 est préservé lors des étapes de CMP effectuées successivement pour planariser la face supérieure des différentes couches sacrificielles minérales 14, 15 déposées. On évite ainsi la fragilité mécanique mentionnée dans le document EP3239670A1 mise en évidence pour une configuration où une portion getter 13 est située sous un détecteur thermique 20 et est protégée par une couche mince sacrificielle carbonée réalisée en polyimide. En effet, dans le cadre de l'invention, les couches sacrificielles minérales 14, 15 ne reposent pas sur la couche sacrificielle carbonée 17, laquelle est située dans une ouverture traversante 16 s'étendant au travers des couches sacrificielles minérales 14, 15.

De plus, l'intégrité de la portion getter 13 est également préservée dans la mesure où la portion getter 13 est protégée par une couche épaisse sacrificielle carbonée et non pas par une couche mince sacrificielle carbonée, de sorte que la dimension de protection peut être sensiblement plus importante. Dans le cadre de l'invention, la couche sacrificielle carbonée 17 est une couche épaisse (et non pas une couche mince) qui entoure entièrement la portion getter 13 dans le plan XY. Elle peut être réalisée en polyimide ou en carbone amorphe. La dimension de protection peut être de l'ordre de quelques dizaines voire centaines de microns, ce qui améliore grandement la protection de la portion getter 13. Elle est mise à profit pour assurer une partie du support de la couche mince d'encapsulation 31 lors du dépôt de celle-ci. Par ailleurs, la portion getter 13 n'est pas située en regard des membranes absorbantes 21 comme c'est le cas dans le document EP3239670A1, ce qui autorise d'utiliser une surface de matériau getter plus importante. De plus, le matériau getter peut être choisi uniquement en fonction de sa propriété de chimisorption, et non pas en fonction d'une propriété supplémentaire de réflecteur optique. Un matériau getter à haute performance de chimisorption peut donc être choisi.

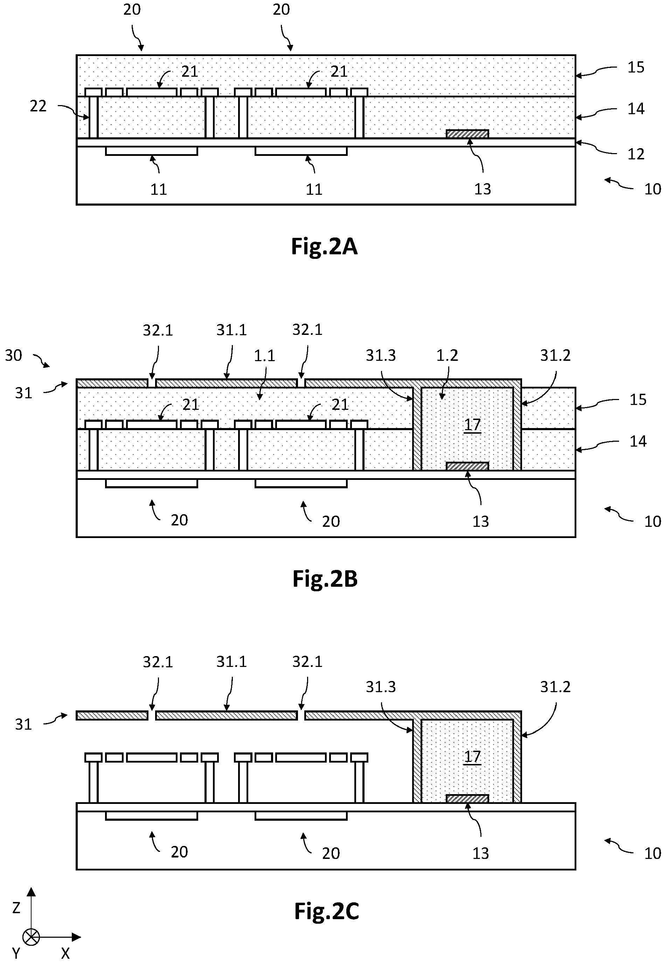

Les figures 2A à 2F illustrent différentes étapes d'un procédé de fabrication d'un dispositif de détection selon un deuxième mode de réalisation. Seule une partie du dispositif de détection est représentée. Ce mode de réalisation diffère de celui décrit précédemment essentiellement en ce que la couche mince d'encapsulation 31 comporte une partie interne 31.3 (également appelée paroi interne) située entre les couches sacrificielles minérales 14, 15 et la couche sacrificielle carbonée 17, assurant une protection physique de la couche sacrificielle carbonée 17 vis-à-vis de la première gravure chimique.

En référence à la fig.2A, on réalise la matrice de détecteurs thermiques 20 sur le substrat de lecture 10, de telle sorte qu'ils soient recouverts par une couche sacrificielle minérale 15. Cette étape est similaire à celle décrite en référence à la fig. 1A, et en diffère ici en ce que la portion getter 13 a été réalisée sur la couche de protection 12 avant le dépôt de la couche sacrificielle minérale 14 et la réalisation des membranes absorbantes 21. La portion getter 13 est ainsi située de manière décalée dans le plan XY par rapport aux détecteurs thermiques 20, et est recouverte par les deux couches sacrificielles minérales 14, 15. Notons toutefois que la réalisation de la portion getter 13 peut être effectuée ici aussi après la réalisation des membranes absorbantes 21 et le dépôt de la couche sacrificielle 15.

En référence à la fig.2B, on réalise ensuite la couche mince d'encapsulation 31 de la structure d'encapsulation 30 de manière similaire à celle décrite en référence à la fig.1B. Cependant, une paroi interne 31.3 s'étend dans le plan XY de manière à séparer la couche sacrificielle carbonée 17 vis-à-vis des couches sacrificielles minérales 14, 15. Elle présente ainsi une face au contact des couches sacrificielles minérales 14, 15, et une face opposée au contact de la couche sacrificielle carbonée 17. Elle repose au contact du substrat de lecture 10 et rejoint suivant l'axe Z la paroi supérieure 31.1 de la couche mince d'encapsulation 31. Ainsi, la paroi interne 31.3 délimite avec la paroi périphérique 31.2 un espace hermétique 1.2 et distinct de l'espace 1.1 dans lequel sont situés les détecteurs thermiques 20.

Des orifices traversants 32.1, formant des premiers évents de libération destinés à permettre l'évacuation des couches sacrificielles minérales 14, 15 hors de la cavité, sont ensuite réalisés par photolithographie et gravure dans la couche mince d'encapsulation 31. Ces premiers évents 32.1 sont situés en regard suivant l'axe Z des couches sacrificielles minérales 14, 15, par exemple au-dessus des membranes absorbantes 21. De préférence, aucun deuxième évent 32.2 débouchant sur la couche sacrificielle carbonée 17 n'est réalisé à ce stade.

En référence à la fig.2C, on effectue la première gravure chimique pour supprimer les deux couches sacrificielles minérales 14, 15, ici par une gravure chimique humide par attaque HF vapeur. Les produits de la réaction chimique sont évacués au travers des premiers évents de libération 32.1. Ainsi, à la différence du premier mode de réalisation, la couche sacrificielle carbonée 17 est totalement préservée par la protection physique assurée par la paroi interne 31.3. Dans le cas où la gravure chimique humide entraîne une gravure partielle de la couche sacrificielle carbonée 17, celle-ci est ici entièrement préservée.

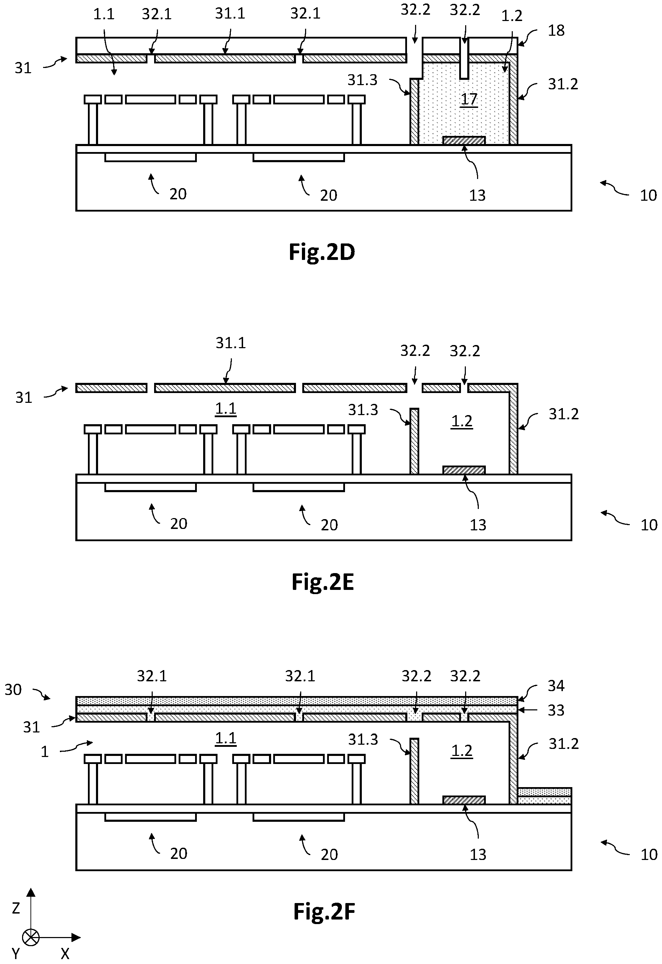

En référence à la fig.2D, on réalise ensuite le ou les deuxièmes évents de libération 32.2 destinés à permettre l'évacuation de la couche sacrificielle carbonée 17 hors de l'espace 1.2 dans lequel se situe la couche sacrificielle carbonée 17. Ces deuxièmes évents 32.2 sont situés en regard suivant l'axe Z de la couche sacrificielle carbonée 17. Au moins un deuxième évent 32.2 est situé à la perpendiculaire de la paroi interne 31.3, de manière à rompre, continûment ou localement, le lien physique de celle-ci avec la paroi supérieure 31.1. Cette étape est effectuée par photolithographie et gravure au moyen d'une photorésine 18 qui est ensuite supprimée. Cette photorésine 18 présente des propriétés de viscosité telles qu'elle ne s'infiltre pas dans les évents 32.1.

En référence à la fig.2E, on effectue la deuxième gravure chimique adaptée à supprimer la couche sacrificielle carbonée 17 et rendre libre la portion getter 13. La gravure chimique est ici une gravure chimique sèche dont l'agent de gravure est ici de l'oxygène présent dans un plasma. Les produits de gravure issus de la couche sacrificielle carbonée 17 s'échappent essentiellement par les deuxièmes évents 32.2. Il y a ainsi une communication entre l'espace 1.1 dans lequel se situent les détecteurs thermiques 20 et l'espace 1.2 dans lequel se situe la portion getter 13.

En référence à la fig.2F, on dépose ensuite la couche de scellement 33 sur la couche mince d'encapsulation 31 pour assurer le scellement, i.e. le bouchage, des différents évents de libération 32.1, 32.2. Et on dépose la couche antireflet 34. On active ensuite la chimisorption de la portion getter 13 par un traitement thermique.

Ainsi, par la réalisation d'un espace hermétique 1.2 formé notamment par la paroi interne 31.3 de la couche mince d'encapsulation 31 dans lequel se situe la couche sacrificielle carbonée 17 et donc la portion getter 13, on évite que la couche sacrificielle carbonée 17 ne soit dégradée par la gravure chimique humide, ici l'attaque HF vapeur, et on améliore encore la protection de la portion getter 13 vis-à-vis de cette gravure. Ce mode de réalisation est particulièrement avantageux lorsque la couche sacrificielle carbonée 17 peut légèrement réagir à l'agent de gravure mis en oeuvre lors de la première gravure chimique.

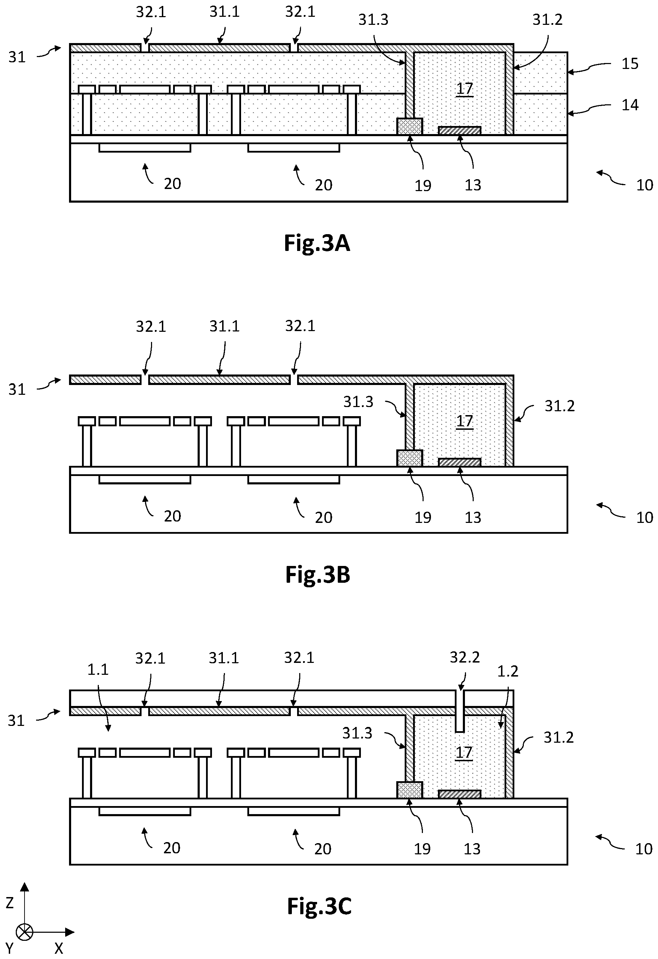

Les figures 3A à 3E illustrent différentes étapes d'un procédé de fabrication d'un dispositif de détection selon une variante du deuxième mode de réalisation. Seule une partie du dispositif de détection est représentée. Cette variante diffère du deuxième mode de réalisation par le moyen utilisé pour assurer la communication entre l'espace 1.1 dans lequel se situe les détecteurs thermiques 20 et l'espace 1.2 dans lequel se situe la couche sacrificielle carbonée 17 et la portion getter 13.

En référence à la fig.3A, une portion d'une autre couche sacrificielle carbonée 17, appelée une portion carbonée 19, est préalablement réalisée sur et au contact du substrat de lecture 10 entre les détecteurs thermiques 20 et la portion getter 13. Cette portion carbonée 19 est réalisée en un matériau carboné sensiblement inerte à la première gravure chimique, ici à l'attaque HF vapeur, et adapté à être supprimé par la deuxième gravure chimique, ici le plasma O₂. Elle peut être réalisée en le même matériau que la couche sacrificielle carbonée 17, ou en un matériau différent. Dans cet exemple, la portion carbonée 19 est réalisée en carbone amorphe, et la couche sacrificielle carbonée 17 est réalisée en polyimide. La couche mince d'encapsulation 31 comporte une paroi interne 31.3 similaire à celle décrite dans le deuxième mode de réalisation, à ceci près qu'elle repose au contact de la portion carbonée 19, et rejoint la paroi supérieure 31.1 suivant l'axe Z.

En référence à la fig.3B, on effectue la première gravure chimique pour supprimer les deux couches sacrificielles minérales 14, 15, ici par une gravure chimique humide par attaque HF vapeur. Les produits de la réaction chimique sont évacués au travers des premiers évents de libération 32.1. Dans la mesure où la portion carbonée 19 est inerte vis-à-vis de l'attaque HF vapeur, il n'y a pas de rupture du lien physique entre la paroi interne 31.3 et le substrat de lecture 10. Aussi, la couche sacrificielle carbonée 17 reste totalement préservée.

En référence à la fig.3C, on réalise ensuite le ou les deuxièmes évents de libération 32.2 destinés à permettre l'évacuation de la couche sacrificielle carbonée 17 hors de l'espace 1.2 dans lequel se situe la couche sacrificielle carbonée 17. Ces deuxièmes évents 32.2 sont situés en regard suivant l'axe Z de la couche sacrificielle carbonée 17. Cependant, à la différence de la fig.2D, il n'est pas réalisé un évent situé à la perpendiculaire de la paroi interne 31.3, de manière à rompre le lien physique de celle-ci avec la paroi supérieure 31.1. La rupture du lien physique sera assurée par la suppression de la portion carbonée 19.

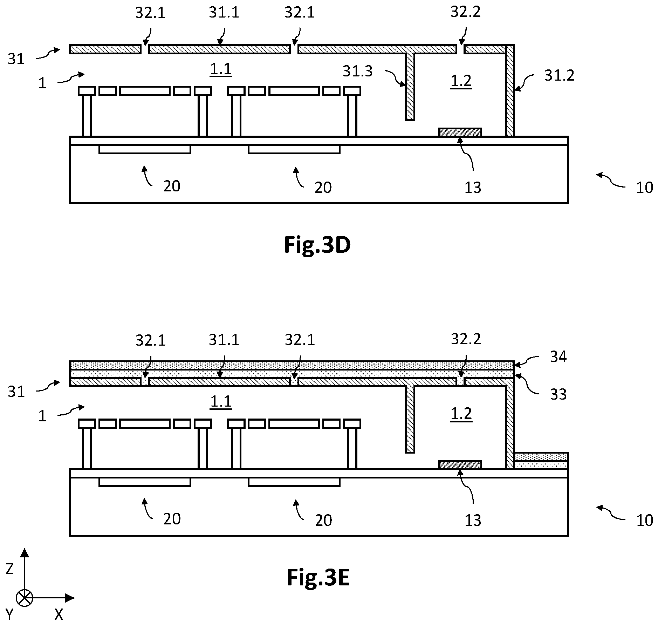

En référence à la fig.3D, on effectue la deuxième gravure chimique pour supprimer la couche sacrificielle carbonée 17 et rendre libre la portion getter 13, mais également pour supprimer la portion carbonée 19. Les produits de gravure issus de la couche sacrificielle carbonée 17 s'échappent par les deuxièmes évents 32.2. Il y a ainsi une communication entre l'espace 1.1 dans lequel se situent les détecteurs thermiques 20 et l'espace 1.2 dans lequel se situe la portion getter 13, cette communication étant effectuée non pas par l'absence de lien physique entre la paroi interne 31.3 et la paroi supérieure 31.1, mais par l'absence de lien physique entre la paroi interne 31.3 et le substrat de lecture 10. Cette absence de lien physique peut être continue ou non le long de la paroi interne 31.3.

En référence à la fig.3E, on dépose ensuite la couche de scellement 33 sur la couche mince d'encapsulation 31 pour assurer le scellement, i.e. le bouchage, des différents évents de libération 32.1, 32.2. Et on dépose la couche antireflet 34. On active ensuite la chimisorption de la portion getter 13 par un traitement thermique.

Des modes de réalisation particuliers viennent d'être décrits. Différentes variantes et modifications apparaîtront à l'homme du métier.

Ainsi, d'une manière générale, l'étape de réalisation de la portion getter 13 peut être effectuée avant ou après celle de réalisation des détecteurs thermiques 20, comme l'illustrent les deux modes de réalisation. Par ailleurs, la portion getter 13 peut s'étendre latéralement dans le plan XY de sorte que la paroi périphérique 31.2 repose au contact de cette dernière, améliorant ainsi l'accroche de la structure d'encapsulation 30 sur le substrat de lecture 10.

## Revendications

1. Procédé de fabrication d'un dispositif de détection d'un rayonnement électromagnétique, comportant les étapes suivantes :
∘ réalisation sur un substrat (10) d'au moins un détecteur thermique (20), lequel est recouvert par au moins une couche sacrificielle minérale (14, 15) réalisée en un matériau minéral apte à être supprimé par une première gravure chimique ;
∘ réalisation d'une ouverture traversante (16) s'étendant au travers de la couche sacrificielle minérale (14, 15) et débouchant sur le substrat (10) ;
∘ réalisation d'une portion getter (13) réalisée en un matériau métallique à effet getter, disposée sur et au contact du substrat (10) et à distance du détecteur thermique (20) dans un plan parallèle au substrat (10) ;
• la portion getter (13) étant située dans l'ouverture traversante (16), à distance d'une bordure latérale (16.1) définie par la couche sacrificielle minérale (14, 15) et délimitant l'ouverture traversante (16) dans le plan parallèle au substrat (10) ;
∘ réalisation d'une couche sacrificielle carbonée (17) réalisée en un matériau carboné inerte à la première gravure chimique et apte à être supprimée par une deuxième gravure chimique,
• de manière à recouvrir la portion getter (13) et à l'entourer dans le plan parallèle au substrat, et à remplir entièrement l'ouverture traversante (16) ;
∘ réalisation d'une couche mince d'encapsulation (31) comportant : une partie supérieure (31.1) reposant sur la couche sacrificielle minérale (15) et sur la couche sacrificielle carbonée (17) ; et une partie périphérique (31.2) s'étendant au travers de la couche sacrificielle minérale (14, 15) et entourant le détecteur thermique (20) et la portion getter (13) ;
∘ suppression de la couche sacrificielle minérale (14, 15) par la première gravure chimique ;
∘ suppression de la couche sacrificielle carbonée (17) par la deuxième gravure chimique.

2. Procédé selon la revendication 1, dans lequel la portion getter (13) est disposée entre le détecteur thermique (20) et la partie périphérique (31.2) de la couche mince d'encapsulation (31).

3. Procédé selon la revendication 1 ou 2, dans lequel la partie périphérique (31.2) comporte une surface interne, orientée vers le détecteur thermique (20), au contact de la couche sacrificielle carbonée (17).

4. Procédé selon l'une quelconque des revendications 1 à 3, dans lequel la couche sacrificielle minérale (15) et la couche sacrificielle carbonée (17) présentent des faces supérieures, opposées au substrat (10), coplanaires.

5. Procédé selon l'une quelconque des revendications 1 à 4, dans lequel le matériau minéral comporte au moins de l'oxyde de silicium ou du nitrure de silicium, et la première gravure chimique est une attaque à l'acide fluorhydrique en phase vapeur.

6. Procédé selon l'une quelconque des revendications 1 à 5, dans lequel le matériau carboné est choisi parmi le carbone amorphe et le polyimide, et la deuxième gravure chimique est une gravure sèche par plasma d'oxygène.

7. Procédé selon l'une quelconque des revendications 1 à 6, dans lequel le matériau métallique à effet getter est choisi parmi le titane, le zirconium, le vanadium, le chrome, le cobalt, le fer, le manganèse, le palladium, le baryum, et/ou l'aluminium, et un alliage de ces métaux.

8. Procédé selon l'une quelconque des revendications 1 à 7, comportant la réalisation d'au moins un premier évent de libération (32.1) et d'au moins un deuxième évent de libération (32.2) au travers de la partie supérieure (31.1) de la couche mince d'encapsulation (31), le premier évent de libération (32.1) débouchant sur la couche sacrificielle minérale (15), et le deuxième évent de libération (32.2) débouchant sur la couche sacrificielle carbonée (17).

9. Procédé selon la revendication 8, dans lequel la réalisation des premier et deuxième évents de libération (32.1, 32.2) est effectuée avant la première gravure chimique, la couche sacrificielle carbonée (17) sous la partie supérieure (31.1) de la couche mince d'encapsulation (31) étant au contact de la couche sacrificielle minérale (15).

10. Procédé selon la revendication 8, dans lequel la couche mince d'encapsulation (31) comporte en outre une partie interne (31.3) s'étendant à partir de la partie supérieure (31.1) en direction du substrat (10), et disposée entre la couche sacrificielle minérale (14, 15) et la couche sacrificielle carbonée (17), de sorte que la couche sacrificielle carbonée (17) sous la partie supérieure (31.1) de la couche mince d'encapsulation (31) est au contact des parties supérieure (31.1), périphérique (31.2) et interne (31.3) de la couche mince d'encapsulation (31).

11. Procédé selon la revendication 10, dans lequel l'étape de réalisation des deuxièmes évents de libération (32.2) comporte, outre la formation d'au moins un deuxième évent de libération (32.2) débouchant sur la couche sacrificielle carbonée (17), la formation d'au moins un évent (32.2) situé à la perpendiculaire de la partie interne (31.3) et assurant une rupture de lien physique, au moins localement, entre la paroi interne (31.3) et la partie supérieure (31.1), assurant ainsi, après la deuxième gravure chimique, une communication entre un premier espace (1.1) dans lequel est situé le détecteur thermique (20) et un deuxième espace (1.2) dans lequel est située la portion getter (13).

12. Procédé selon la revendication 10, dans lequel la partie interne (31.3) repose au contact d'une portion carbonée (19) disposée au contact du substrat (10) et réalisée en un matériau carboné inerte à la première gravure chimique et apte à être supprimé par la deuxième gravure chimique, de sorte que la deuxième gravure chimique assure la suppression de la couche sacrificielle carbonée (17) et rendant libre la portion getter (13), et assure la suppression de la portion carbonée (19) et formant une communication entre un premier espace (1.1) dans lequel est situé le détecteur thermique (20) et un deuxième espace (1.2) dans lequel est située la portion getter (13).

13. Procédé selon l'une quelconque des revendications 1 à 12, dans lequel plusieurs détecteurs thermiques (20) sont réalisés de manière simultanée, comportant chacun une membrane adaptée à absorber le rayonnement électromagnétique à détecter, suspendue au-dessus du substrat (10) par des piliers d'ancrage (22) et thermiquement isolée de celui-ci par des bras de maintien.

14. Procédé selon l'une quelconque des revendications 1 à 13, dans lequel la partie supérieure (31.1) de la couche mince d'encapsulation (31) repose sur et au contact de la couche sacrificielle minérale (15), et repose sur et au contact de la couche sacrificielle carbonée (17).

## Patentansprüche

1. Verfahren zum Fertigen einer Vorrichtung zum Detektieren einer elektromagnetischen Strahlung, das folgende Schritte umfasst:
- Herstellen mindestens eines thermischen Detektors (20), der von mindestens einer mineralischen Opferschicht (14, 15) bedeckt ist, die aus einem mineralischen Material hergestellt ist, das dazu ausgelegt ist, durch ein erstes chemisches Ätzen entfernt zu werden, auf einem Substrat (10);
- Herstellen einer Durchgangsöffnung (16), die sich durch die mineralische Opferschicht (14, 15) erstreckt und in das Substrat (10) mündet;
- Herstellen eines Getter-Abschnitts (13), der aus einem metallischen Material mit Getter-Effekt hergestellt ist und auf und in Kontakt mit dem Substrat (10) und in einem Abstand vom thermischen Detektor (20) in einer Ebene parallel zum Substrat (10) angeordnet ist,
-- wobei sich der Getter-Abschnitt (13) in der Durchgangsöffnung (16) in einem Abstand von einem Seitenrand (16.1) befindet, der durch die mineralische Opferschicht (14, 15) definiert wird und die Durchgangsöffnung (16) in der Ebene parallel zum Substrat (10) begrenzt;
- Herstellen einer kohlenstoffhaltigen Opferschicht (17), die aus einem dem ersten chemischen Ätzen gegenüber inerten, kohlenstoffhaltigen Material hergestellt und dazu ausgelegt ist, durch ein zweites chemisches Ätzen entfernt zu werden,
-- derart, um den Getter-Abschnitt (13) zu bedecken und ihn in der Ebene parallel zum Substrat zu umgeben und um die Durchgangsöffnung (16) vollständig auszufüllen;
- Herstellen einer dünnen Einkapselungsschicht (31), die Folgendes umfasst: einen oberen Teil (31.1), der auf der mineralischen Opferschicht (15) und auf der kohlenstoffhaltigen Opferschicht (17) liegt; und einen peripheren Teil (31.2), der sich durch die mineralische Opferschicht (14, 15) erstreckt und den thermischen Detektor (20) und den Getter-Abschnitt (13) umgibt;
- Entfernen der mineralischen Opferschicht (14, 15) durch das erste chemische Ätzen;
- Entfernen der kohlenstoffhaltigen Opferschicht (17) durch das zweite chemische Ätzen.

2. Verfahren nach Anspruch 1, wobei der Getter-Abschnitt (13) zwischen dem thermischen Detektor (20) und dem peripheren Teil (31.2) der dünnen Einkapselungsschicht (31) angeordnet ist.

3. Verfahren nach Anspruch 1 oder 2, wobei der periphere Teil (31.2) eine innere Oberfläche umfasst, die zum thermischen Detektor (20) hin ausgerichtet ist und mit der kohlenstoffhaltigen Opferschicht (17) in Kontakt steht.

4. Verfahren nach einem der Ansprüche 1 bis 3, wobei die mineralische Opferschicht (15) und die kohlenstoffhaltige Opferschicht (17) koplanare obere Oberflächen aufweisen, die dem Substrat (10) gegenüberliegen.

5. Verfahren nach einem der Ansprüche 1 bis 4, wobei das mineralische Material mindestens Siliziumoxid oder Siliziumnitrid umfasst, und das erste chemische Ätzen eine Ätzung mit Flusssäure in der Dampfphase ist.

6. Verfahren nach einem der Ansprüche 1 bis 5, wobei das kohlenstoffhaltige Material aus amorphem Kohlenstoff und Polyimid ausgewählt wird, und das zweite chemische Ätzen eine Trockenätzung mittels Sauerstoffplasma ist.

7. Verfahren nach einem der Ansprüche 1 bis 6, wobei das metallische Material mit Getter-Effekt aus Titan, Zirconium, Vanadium, Chrom, Kobalt, Eisen, Mangan, Palladium, Barium und/oder Aluminium und einer Legierung dieser Metalle ausgewählt wird.

8. Verfahren nach einem der Ansprüche 1 bis 7, umfassend das Herstellen mindestens eines ersten Entlüftungslochs (32.1) und mindestens eines zweiten Entlüftungslochs (32.2) durch den oberen Teil (31.1) der dünnen Einkapselungsschicht (31), wobei das erste Entlüftungsloch (32.1) in der mineralischen Opferschicht (15) mündet und das zweite Entlüftungsloch (32.2) in der kohlenstoffhaltigen Opferschicht (17) mündet.

9. Verfahren nach Anspruch 8, wobei das Herstellen der ersten und zweiten Entlüftungslöcher (32.1, 32.2) vor dem ersten chemischen Ätzen durchgeführt wird, wobei die kohlenstoffhaltige Opferschicht (17) unter dem oberen Teil (31.1) der dünnen Einkapselungsschicht (31) in Kontakt mit der mineralischen Opferschicht (15) steht.

10. Verfahren nach Anspruch 8, wobei die dünne Einkapselungsschicht (31) ferner einen inneren Teil (31.3) umfasst, der sich vom oberen Teil (31.1) in Richtung des Substrats (10) erstreckt und zwischen der mineralischen Opferschicht (14, 15) und der kohlenstoffhaltigen Opferschicht (17) angeordnet ist, so dass die kohlenstoffhaltige Opferschicht (17) unter dem oberen Teil (31.1) der dünnen Einkapselungsschicht (31) in Kontakt mit dem oberen (31.1), dem peripheren (31.2) und dem inneren Teil (31.3) der dünnen Einkapselungsschicht (31) steht.

11. Verfahren nach Anspruch 10, wobei der Schritt des Herstellens der zweiten Entlüftungslöcher (32.2) ferner das Bilden mindestens eines zweiten Entlüftungslochs (32.2), das in der kohlenstoffhaltigen Opferschicht (17) mündet, und das Bilden mindestens eines Lochs (32.2) umfasst, das sich senkrecht zum inneren Teil (31.3) befindet und mindestens lokal eine Unterbrechung der physischen Verbindung zwischen der Innenwand (31.3) und dem oberen Teil (31.1) gewährleistet, wodurch nach dem zweiten chemischen Ätzen eine Verbindung zwischen einem ersten Raum (1.1), in dem sich der thermische Detektor (20) befindet, und einem zweiten Raum (1.2), in dem sich der Getter-Abschnitt (13) befindet, gewährleistet wird.

12. Verfahren nach Anspruch 10, wobei der innere Teil (31.3) in Kontakt mit einem kohlenstoffhaltigen Abschnitt (19) ruht, der mit dem Substrat (10) in Kontakt angeordnet, aus einem dem ersten chemischen Ätzen gegenüber inerten, kohlenstoffhaltigen Material hergestellt und dazu ausgelegt ist, durch das zweite chemische Ätzen entfernt zu werden, so dass das zweite chemische Ätzen das Entfernen der kohlenstoffhaltigen Opferschicht (17) und das Freigeben des Getter-Abschnitts (13) gewährleistet und das Entfernen des kohlenstoffhaltigen Abschnitts (19) und das Bilden einer Verbindung zwischen einem ersten Raum (1.1), in dem sich der thermische Detektor (20) befindet, und einem zweiten Raum (1.2), in dem sich der Getter-Abschnitt (13) befindet, gewährleistet.

13. Verfahren nach einem der Ansprüche 1 bis 12, wobei mehrere thermische Detektoren (20) gleichzeitig hergestellt werden, die jeweils eine Membran umfassen, die dazu ausgebildet ist, die zu detektierende elektromagnetische Strahlung zu absorbieren, die durch Verankerungspfeiler (22) über dem Substrat (10) aufgehängt und von diesem durch Haltearme thermisch isoliert ist.

14. Verfahren nach einem der Ansprüche 1 bis 13, wobei der obere Teil (31.1) der dünnen Einkapselungsschicht (31) auf oder in Kontakt mit der mineralischen Opferschicht (15) ruht und auf oder in Kontakt mit der kohlenstoffhaltigen Opferschicht (17) ruht.

## Claims

1. A method for manufacturing a device for detecting an electromagnetic radiation, including the following steps:
∘ production, on a substrate (10), of at least one thermal detector (20), which is covered by at least one mineral sacrificial layer (14, 15) made of a mineral material capable of being removed by a first chemical etching;
∘ production a through opening (16) extending through the mineral sacrificial layer (14, 15) and opening onto the substrate (10);
∘ production of a getter portion (13) made of a metal material with a getter effect, disposed on and in contact with the substrate (10) and at a distance from the thermal detector (20) in a plane which is parallel to the substrate (10);
• the getter portion (13) being located in the through opening (16), at a distance from a lateral border (16.1) defined by the mineral sacrificial layer (14, 15) and delimiting the through opening (16) in the plane which is parallel to the substrate (10);
∘ production of a carbonaceous sacrificial layer (17) made of a carbonaceous material inert to the first chemical etching and capable of being removed by a second chemical etching,
• so as to cover the getter portion (13) and surround it in the plane which is parallel to the substrate, and to completely fill the through opening (16);
∘ production of a thin encapsulation layer (31) including: an upper portion (31.1) resting on the mineral sacrificial layer (15) and on the carbonaceous sacrificial layer (17); and a peripheral portion (31.2) extending through the mineral sacrificial layer (14, 15) and surrounding the thermal detector (20) and the getter portion (13);
∘ removal of the mineral sacrificial layer (14, 15) by the first chemical etching;
∘ removal of the carbonaceous sacrificial layer (17) by the second chemical etching.

2. The method according to claim 1, wherein the getter portion (13) is disposed between the thermal detector (20) and the peripheral portion (31.2) of the thin encapsulation layer (31).

3. The method according to claim 1 or 2, wherein the peripheral portion (31.2) includes an inner surface, oriented towards the thermal detector (20), in contact with the carbonaceous sacrificial layer (17).

4. The method according to any one of claims 1 to 3, wherein the mineral sacrificial layer (15) and the carbonaceous sacrificial layer (17) have coplanar upper faces, opposite to the substrate (10).

5. The method according to any one of claims 1 to 4, wherein the mineral material includes at least silicon oxide or silicon nitride, and the first chemical etching is an attack with hydrofluoric acid in the vapour phase.

6. The method according to any one of claims 1 to 5, wherein the carbonaceous material is selected from amorphous carbon and polyimide, and the second chemical etching is a dry etching by oxygen plasma.

7. The method according to any one of claims 1 to 6, wherein the metal material with a getter effect is selected from titanium, zirconium, vanadium, chromium, cobalt, iron, manganese, palladium, barium, and/or aluminium, and an alloy of these metals.

8. The method according to any one of claims 1 to 7, including the production of at least one first release vent (32.1) and at least one second release vent (32.2) through the face of the upper portion (31.1) of the thin encapsulation layer (31), the first release vent (32.1) opening onto the mineral sacrificial layer (15), and the second release vent (32.2) opening onto the carbonaceous sacrificial layer (17).

9. The method according to claim 8, wherein the production of the first and second release vents (32.1, 32.2) is performed before the first chemical etching, the carbonaceous sacrificial layer (17) under the upper portion (31.1) of the thin encapsulation layer (31) being in contact with the mineral sacrificial layer (15).

10. The method according to claim 8, wherein the thin encapsulation layer (31) further includes an inner portion (31.3) extending from the upper portion (31.1) towards the substrate (10), and disposed between the mineral sacrificial layer (14, 15) and the carbonaceous sacrificial layer (17), such that the carbonaceous sacrificial layer (17) under the upper portion (31.1) of the thin encapsulation layer (31) is in contact with the upper (31.1), peripheral (31.2) and inner (31.3) portions of the thin encapsulation layer (31).

11. The method according to claim 10, wherein the step of producing the second release vents (32.2) includes, in addition to the formation of at least one second release vent (32.2) opening onto the carbonaceous sacrificial layer (17), the formation of at least one vent (32.2) located perpendicular to the inner portion (31.3) and ensuring a break in physical connection, at least locally, between the inner wall (31.3) and the upper portion (31.1), thus ensuring, after the second chemical etching, a communication between a first space (1.1) in which the thermal detector (20) is located and a second space (1.2) in which the getter portion (13) is located.

12. The method according to claim 10, wherein the inner portion (31.3) rests in contact with a carbonaceous portion (19) disposed in contact with the substrate (10) and made of a carbonaceous material inert to the first chemical etching and capable of being removed by the second chemical etching, such that the second chemical etching ensures the removal of the carbonaceous sacrificial layer (17) and making the getter portion (13) free, and ensures the removal of the carbonaceous portion (19) and forming a communication between a first space (1.1) in which the thermal detector (20) is located and a second space (1.2) in which the getter portion (13) is located.

13. The method according to any one of claims 1 to 12, wherein several thermal detectors (20) are produced simultaneously, each including a membrane adapted to absorb the electromagnetic radiation to be detected, suspended above the substrate (10) by anchoring pillars (22) and thermally isolated therefrom by holding arms.

14. The method according to any one of claims 1 to 13, wherein the upper portion (31.1) of the thin encapsulation layer (31) rests on and in contact with the mineral sacrificial layer (15), and rests on and in contact with the carbonaceous sacrificial layer (17).
